Europäisches Patentamt

European Patent Office

Office européen des brevets

(19)

(11) Publication number: **0 292 940**

**A2**

(12) # EUROPEAN PATENT APPLICATION

(21) Application number: 88108337.2

(51) Int. Cl.4: **H01L 39/12 , C04B 35/00**

(22) Date of filing: 25.05.88

(30) Priority: 25.05.87 JP 127686/87
30.05.87 JP 133278/87
30.05.87 JP 133279/87

(43) Date of publication of application:
**30.11.88 Bulletin 88/48**

(84) Designated Contracting States:
**DE FR GB**

(71) Applicant: **NIPPON STEEL CORPORATION**
**6-3 Otemachi 2-chome Chiyoda-ku**
**Tokyo 100(JP)**

(72) Inventor: **Murakami, Masato Nippon Steel**
**Corporation**
**R & D Laboratories-I No. 1618, Ida**
**Nakahara-ku**
**Kawasaki City Kanagawa Pref.(JP)**
Inventor: **Morita, Mitsuru Nippon Steel**
**Corporation**
**R & D Laboratories-I No. 1618, Ida**
**Nakahara-ku**
**Kawasaki City Kanagawa Pref.(JP)**
Inventor: **Teshima, Hidekazu Nippon Steel**
**Corporation**
**R & D Laboratories-I No. 1618, Ida**
**Nakahara-ku**
**Kawasaki City Kanagawa Pref.(JP)**
Inventor: **Matsuda, Shoichi Nippon Steel**
**Corporation**
**R & D Laboratories-I No. 1618, Ida**
**Nakahara-ku**
**Kawasaki City Kanagawa Pref.(JP)**

(74) Representative: **Kador & Partner**
**Corneliusstrasse 15**
**D-8000 München 5(DE)**

(54) Superconductor.

(57) A superconductive ceramics represented by the general formula: $Z_1 Ba_2 Cu_3 O_7$. Here, Z is a mixture of a plurality of rare-earth metals including scandium and or ytterbium mixed in a prescribed ratio. As a high-temperature superconductor this substance exhibits a high critical current density.

Figure 1

EP 0 292 940 A2

## SUPERCONDUCTOR

## BACKGROUND OF THE INVENTION

### 1. Field of the Invention

The present invention relates to high-temperature superconductors, and particularly to superconductive ceramics of oxides having a high critical current density.

Superconductors are employed in superconducting-magnet type electrical instruments such as generators, transformers, electrical power storage equipment, magnetically levitated motor cars and magnetic resonance imaging equipment, and in electronic devices such as Josephson-junction devices.

### 2. Description of the Related Art

As superconductive materials, metal elements, alloys or intermetallic compounds of these metals, organic and ceramics materials are known. Recently, considerable research and development is being conducted relating to high-temperature superconducting ceramics of Y-Ba-Cu-O compound systems, i.e. which exhibit superconductivity at a critical temperature Tc higher than 77 K, the boiling point of liquid nitrogen.

Other than what is cited in the following examples, there is almost nothing in the known prior art pertaining to superconductive ceramics.

U. S. Patent No. 3932315 (issued on January 13, 1976 to A. W. Sleight) discloses that a perovskite-type substance constituted of $Ba_{1-x}-A_x-Pb_{1-y}Bi_y-O_3$ is a superconductor exhibiting a critical temperature of $Tc \simeq 12$ K. To the best knowledge of the present inventors, this is the earliest superconductive ceramics patent.

In their paper "Possible High Tc Superconductivity in the Ba-La-Cu-O System" (April 17, 1986), Bednorz and Müller stated that superconductivity was observed in a $Ba_5La_4Cu_5O_5$ system at a Tc in the 30 K range. This was the first report of superconductive ceramics having copper as a constituent element.

However, the two examples of the prior art cited above are both related to superconductive ceramics having a low Tc, and were of little practical utility.

The first unambiguous report of the existence of high-temperature superconductors was a paper by C. W. Chu (Physical Review Letters, Vol. 58 P. 908 March 2, 1987) which reported superconductivity exhibited by a Y-Ba-Cu-O compound system at a Tc of 90 K, exceeding the 77 K boiling point of liquid nitrogen.

From subsequent research it has been generally confirmed that the above high-temperature superconductor is constituted of $YBa_2Cu_3O_7$ in a double perovskite-type layer structure. However, while it is recognized that $YBa_2Cu_3O_7$ produced by a certain appropriate method exhibits a certain superconductivity, particularly at a Tc in the order of 90 K, according to print media reports the critical current density Jc thereof is in the order of 100 to 200 $A/cm^2$. Even with pre-processing of the raw materials or heat-treatment, the best Jc value that can be obtained is no more than 350 to 400 $A/cm^2$, which for practical purposes is an unsatisfactory level.

In addition, among the information that has appeared so far there have been few reports relating to the Jc and virtually no specific proposals on how to improve the Jc. Such being the case, a major task in this field has concerned the provision of a practical high-temperature superconductor possessing a high critical current density Jc.

## SUMMARY OF THE INVENTION

An object of the present invention is therefore to provide a novel superconductor that has both a high critical temperature and a high current density.

The gist of the present invention is that, with reference to superconductive ceramics of copper-containing oxides represented by the general formula $R_1A_2Cu_3O_7$, wherein R is a rare-earth metal and A is an alkali earth metal, R is constituted not of a single element (for example, La or Y) but is instead constituted of a mixture of a plurality of rare-earth metals including specific elements having a pronounced superconductivity-improving action. The present inventors have found the above specific elements to be scandium (Sc) and ytterbium (Yb). That is the present invention provides one mixture selected from among four types. Specifically, with Z being one selected from among four comprising: a mixture of Y and Sc in a ratio (atomic percentage) of Y: 80 to 97%, Sc: 3 to 20%; a mixture of Yb and Sc in a ratio (atomic percentage) of Yb: 94 to 99%, Sc: to 6%; a mixture of Yb and Y in a ratio (atomic percentage) of Yb: 50 to 85%, Y: 15 to 50%; and a mixture $Z'$ of Yb and Y in a ratio (atomic percentage) of Yb: 50 to 85%, Y: 15 to 50% mixed with Sc in a ratio (atomic ratio) of 0.2 to 2%, forming a superconductor constituted substantially of $Z_1 Ba_2 Cu_3 O_7$.

In strict terms, the above "constituted substantially" encompasses the $Z_1 Ba_2 Cu_3 O_{7-x}$ structure that generally is ultimately produced by the loss of some of the oxygen atoms as a result of the influence of production conditions and/or storage conditions on substances of the system oxides of the present invention.


## BRIEF DESCRIPTION OF THE DRAWINGS


The present invention will be better understood from the description set forth below with reference to the drawings in which:

Figure 1 is a graph showing the critical current density (Jc) improvement effect in a high-temperature (77 K) Sc-Y type compound superconductor according to the present invention; the vertical axis shows the degree of improvement in the Jc and the horizontal axis the Sc-Y mixture ratio. (In Figures 1 to 4 the Jc comparative reference value is the critical current density of a pure Y-type superconductor.)

Figure 2 is a graph showing the Jc improvement effect in an Sc-Yb type compound high-temperature superconductor; the vertical axis shows the degree of improvement in the Jc and the horizontal axis the Sc-Yb mixture ratio.

Figure 3 is a graph showing the Jc improvement effect in a Y-Yb type compound high-temperature superconductor; the vertical axis shows the degree of improvement in the Jc and the horizontal axis the Y-Yb mixture ratio.

Figure 4 is a graph showing the Jc improvement effect in an Sc-Y-Yb compound high-temperature superconductor. The solid line represents the Jc with the addition of 1 atomic percent of (Yb + Y) Sc and the broken line represents the value $(J'c)$ when no Sc is added; the horizontal axis shows the degree of improvement in the Jc and the horizontal axis the Y-Yb ratio.


## DESCRIPTION OF THE PREFERRED EMBODIMENT


The actions and effects were investigated of representative forms of an $R_1 A_2 Cu_3 O_7$ system superconductor characterized by being a mixture of rare-earth metal elements including Sc and/or Yb, in accordance with the present invention

(1) First, the relationship between high-temperature superconductivity, particularly critical current density, and chemical composition will be described with respect to Sc-Y compound type superconductive ceramics, i.e. $(Sc, Y) \cdot Ba_2 Cu_3 O_7$.

Like Y and La, Sc is classified in the periodic table as a group IIIA element. It is considered difficult to make Sc a superconductor, and there are no reports of a superconductor having Sc as an effective constituent. In fact, the present inventors investigated superconductivity in an $ScBa_2 Cu_3 O_7$ compound produced by the same method used to produce a $YBa_2 Cu_3 O_7$ type superconductor, and confirmed that $ScBa_2 Cu_3 O_7$ is an insulator at 77 K.

However, from further research into the effect on superconductivity of mixtures of Sc and Y, it was found that while the mixture continued to exhibit no superconductivity when there was an excessive amount of Sc, when the above ratio of the two elements was appropriately selected, the unexpected result was the formation of a far better superconductor than Y alone. Specifically, a compound that is substantially $Z_1 Ba_2 Cu_3 O_7$, where Z is a mixture of Y (yttrium) and Sc (scandium) in a ratio of Y: 80 to 97% and Sc: 3 to 20%, (atomic percentage), exhibits a critical temperature that is the same as, or better than, that exhibited

by $YBa_2Cu_3O_7$ produced by the same method, and exhibits a far higher critical current density. The compound $Z_1Ba_2Cu_3O_7$ produced by the mixing of Sc and Y in the above numerical range, i.e., $(Y, Sc)_1Ba_2Cu_3O_7$, becomes a superconductor having a high critical current density, by undergoing a slight change in its lattice constant while maintaining its double-layer perovskite structure.

The effects relating to the improvement in the critical current density of an Sc-Y mixture $(Y, Sc)_1Ba_2Cu_3O_7$ system high-temperature superconductor will now be shown quantitatively.

Compared with a $YBa_2Cu_3O_7$ composition, an improvement of some 20% or more is observed in the critical current density obtained with an Sc-Y mixture where the ratio of Sc is in the range of 3 to 20% (atomic percentage). An Sc ratio in the range of 5 to 15% is more preferable as this provides an improvement of 100% or more; most preferable is an Sc ratio in the range of 8 to 12%, as this enables an improvement of some 200% to be attained. On the other hand, an Sc ratio of Sc > 25% brings about a deterioration in critical current density, which continues to decline as the amount of Sc is increased, and as such does not allow the object of the invention to be achieved.

(2) Second, the relationship between high-temperature superconductivity, particularly critical current density, and chemical composition will be described with respect to Sc-Yb compound type superconductive ceramics, i.e. $(Sc, Yb)_1Ba_2Cu_3O_7$.

In the periodic table Yb is a group IIIA lanthanide. There are no known reports on critical current density in a Yb-Ba-Cu system oxide high-temperature superconductor. The present inventors investigated conductivity in a $YbBa_2Cu_3O_7$ compound produced by the same method used to produce a $YBa_2Cu_3O_7$ type superconductor, and discovered that at 77 K $YbBa_2Cu_3O_7$ exhibited a critical current density that was about three times higher than that of $YBa_2Cu_3O_7$. We then sought ways of further improving the critical current density, based on $YbBa_2Cu_3O_7$.

Like Y and La, Sc is classified in the periodic table as a group IIIA element. It is considered difficult to make Sc a superconductor, and there are no reports of a superconductor having Sc as an effective constituent. In fact, the present inventors investigated superconductivity in an $ScBa_2Cu_3O_7$ compound produced by the same method used to produce a $YBa_2Cu_3O_7$ type superconductor, and confirmed that $ScBa_2Cu_3O_7$ is an insulator at 77 K.

However, from further research into the effect on superconductivity of mixtures of Sc and Yb, it was found that while the mixture continued to exhibit no superconductivity when there was an excessive amount of Sc, when the above ratio of the two elements was appropriately selected, the unexpected result was the formation of a far better superconductor than Yb alone. Specifically, a compound that is substantially $Z_1Ba_2Cu_3O_7$ where Z is a mixture of Yb and Sc in a ratio of Yb: 94 to 99% and Sc: 1 to 6% (atomic percentage), exhibits a critical temperature that is the same as, or better than, that exhibited by $YbBa_2Cu_3O_7$ produced by the same method, and exhibits a far higher critical current density. The compound $Z_1Ba_2Cu_3O_7$ produced by the mixing of Sc and Yb in the above numerical range, i.e., $(Yb, Sc)_1Ba_2Cu_3O_7$, becomes a superconductor having a high critical current density, by undergoing a slight change in its lattice constant while maintaining its double-layer perovskite structure.

The effects relating to the improvement in the critical current density of an Sc-Yb mixture $(Yb, Sc)_1Ba_2Cu_3O_7$ system high-temperature superconductor will now be shown quantitatively.

Compared with a $YBa_2Cu_3O_7$ composition [and compared with a $YbBa_2Cu_3O_7$ composition], an improvement of some 250% [20%] or more is observed in the critical current density obtained with an Sc-Yb mixture where the ratio of Sc is in the range of 1 to 6% (atomic percentage). An Sc ratio in the range of 1.5 to 5.5% is more preferable as this provides an improvement of some 300% [30%] or more; and most preferable is an Sc ratio in the range of 2 to 4.5%, as this enables an improvement of some 350% [50%] to be attained. On the other hand, an Sc ratio of Sc > 7% brings about a deterioration in critical current density, which continues to decline as the amount of Sc is increased, and as such does not allow the object of the invention to be achieved.

(3) Third, the relationship between high-temperature superconductivity, particularly critical current density, and chemical composition will be described with respect to Yb-Y compound type superconductive ceramics, i.e. $(Yb, Y)_1Ba_2Cu_3O_7$.

In the periodic table Yb is a group IIIA lanthanide. There are no known reports on critical current density in a Yb-Ba-Cu system oxide high-temperature superconductor. The present inventors investigated conductivity in a $YbBa_2Cu_3O_7$ compound produced by the same method used to produce a $YBa_2Cu_3O_7$ type superconductor, and discovered that at 77 K $YbBa_2Cu_3O_7$ exhibited a critical current density that was about three times higher than that of $YBa_2Cu_3O_7$. We then sought ways of further improving the critical current density, based on $YbBa_2Cu_3O_7$.

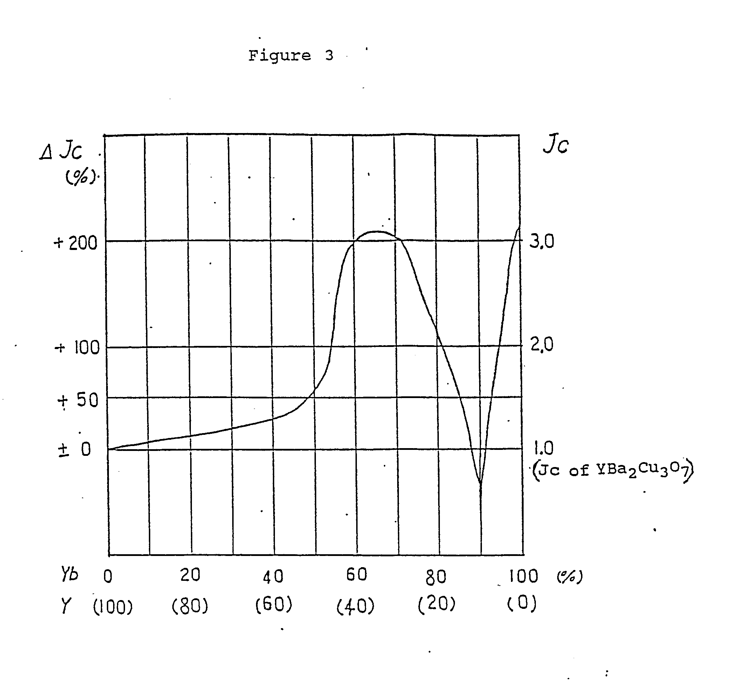

Focussing on the difference in superconductivity between these Yb-system and Y-system oxides, studies were made relating to critical current densities of $M_1Ba_2Cu_3O_7$ compounds, with mixtures of various ratios of both Yb and Y being used as M (rare-earth metal elements, or mixtures thereof). Figure 3 shows what was discovered by the studies. It is clear from Figure 3 that the relationship between the Y-Yb mixture ratio and critical current density Jc is strongly characterized by a maximum Jc in the region of a ratio of Y: 35% (Yb: 65%), and a minimum Jc in the region of a ratio of Y: 10% (Yb: 90%).

The effects relating to the improvement in the critical current density of a Y-Yb mixture (Y, Yb)-$_1$Ba$_2$Cu$_3$O$_7$ system high-temperature superconductor will now be shown quantitatively.

Compared with a YBa$_2$Cu$_3$O$_7$ composition, an improvement of some 50% or more is observed in the critical current density obtained with a Y-Yb mixture where the ratio of Y is in the range of 15 to 50% (atomic percentage). A Y ratio in the range of 20 to 45% is more preferable as this provides an improvement of some 100% or more; and most preferable is a Y ratio in the range of 30 to 40%, as this enables an improvement of some 200% to be attained. In addition, Y ≤ 8% is also effective in improving the Jc. No particular improvement in the Jc is seen with other Y-Yb mixture ratios, and then the Y ratio is around 10% the Jc drops below the level of the Jc obtained with YBa$_2$Cu$_3$O$_7$. Critical temperature Tc is the same as, or better than, that obtained with YBa$_2$Cu$_3$O$_7$.

(4) Fourth, Sc-Yb-Y compound type superconductive ceramics will be described.

Like Y and La, Sc is classified in the periodic table as a group IIIA element. It is considered difficult to make Sc a superconductor, and there are no reports of a superconductor having Sc as an effective constituent. In fact, the present inventors investigated superconductivity in an ScBa$_2$Cu$_3$O$_7$ compound produced by the same method used to produce a YBa$_2$Cu$_3$O$_7$ type superconductor, and confirmed that ScBa$_2$Cu$_3$O$_7$ is an insulator at 77 K.

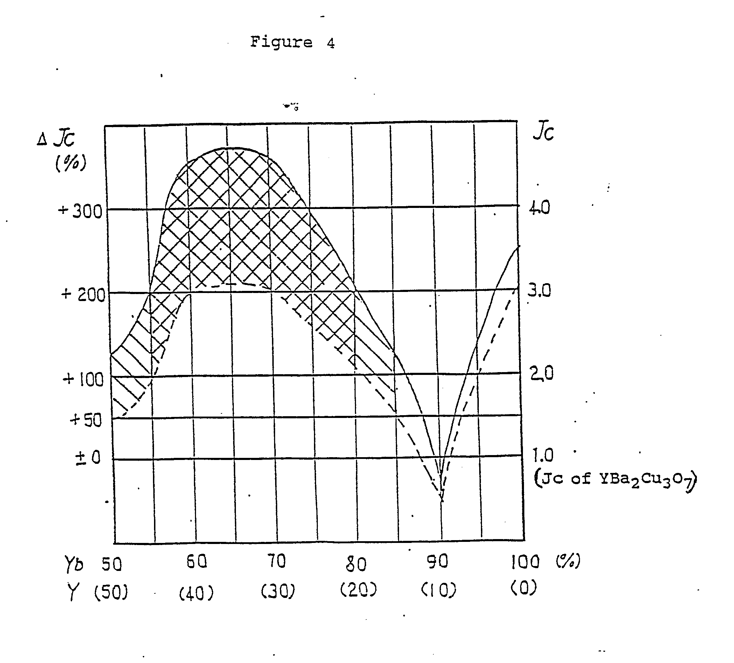

However, from further research into the effect on superconductivity of mixtures of Sc and (Yb + Y), it was found that while the mixture continued to exhibit no superconductivity when there was an excessive amount of Sc, when the above ratio of the two elements was appropriately selected, the unexpected result was the formation of a far better superconductor than just Y-Yb (with no Sc added). Specifically, a compound that is substantially Z$_1$Ba$_2$Cu$_3$O$_7$ constituted of Z$'$ which is a mixture of Yb and Y in a ratio of Yb: 50 to 85% and Y: 15 to 50% (by atomic percentage), and Z which is a mixture (by atomic ratio) of 0.2 to 2.0% Sc (scandium) of the said Z$'$ and the (Yb + Y) of Z$'$, exhibits a critical temperature that is the same as, or better than, that exhibited by (Yb, Y)Ba$_2$Cu$_3$O$_7$ produced by the same method, and exhibits a far higher critical current density. Representative results of the effect of adding Sc are illustrated in Figure 4.

The effects relating to the improvement in the critical current density of an M$_1$Ba$_2$Cu$_3$O$_7$ system high-temperature superconductor obtained by the addition of Sc to (Yb + Y) will now be shown quantitatively. (Here, M is a rare-earth metal element or a mixture thereof.)

Compared with a YBa$_2$Cu$_3$O$_7$ composition [and compared with a (Yb, Y)$_1$Ba$_2$Cu$_3$O$_7$ composition with no Sc added], an improvement of some 100% [50%] or more is observed in the critical current density (Jc) obtained with a Sc-Y-Yb mixture where the ratio of Y is in the range of 15 to 50% (atomic percentage) when the ratio of added Sc, i.e., Sc/(Y + Yb), is 1%. More preferable is an Y ratio in the range of 20 to 45% as this provides an improvement of some 200% [50%] or more; and most preferable is an Y ratio in the range of 30 to 40%, as this enables an improvement of some 350% [50%] to be attained.

The influence of the addition ratio of Sc on the Jc improvement effect is also related to the Y-Yb mixture ratio, but in the range of Y: 20 to 45% it is more or less constant, an Sc addition ratio of 0.2% producing about a 10% improvement in the Jc. The relationship between increases in the Sc and the improvement in the Jc is more less linear until the ratio of added Sc reaches about 1%, which is more or less saturation. More than 2% Sc will in fact result in a reduction in the Jc.

EXAMPLES

The superconductivity improvement effect of representative rare-earth metal element compound compositions according to the present invention will now be specifically described by means of the following examples.

Our research showed that even when the compositions of ceramics system superconductors are identical, differences in production conditions (for example, the purity of the raw materials, the uniformity of the dispersion of the various constituents, heat-treatment conditions) will generally result in non-uniformity of the end superconductivity characteristics.

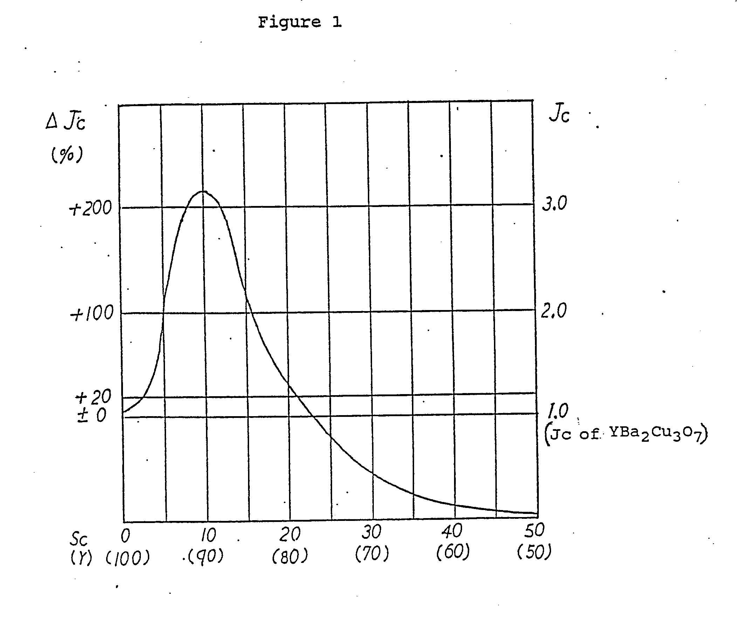

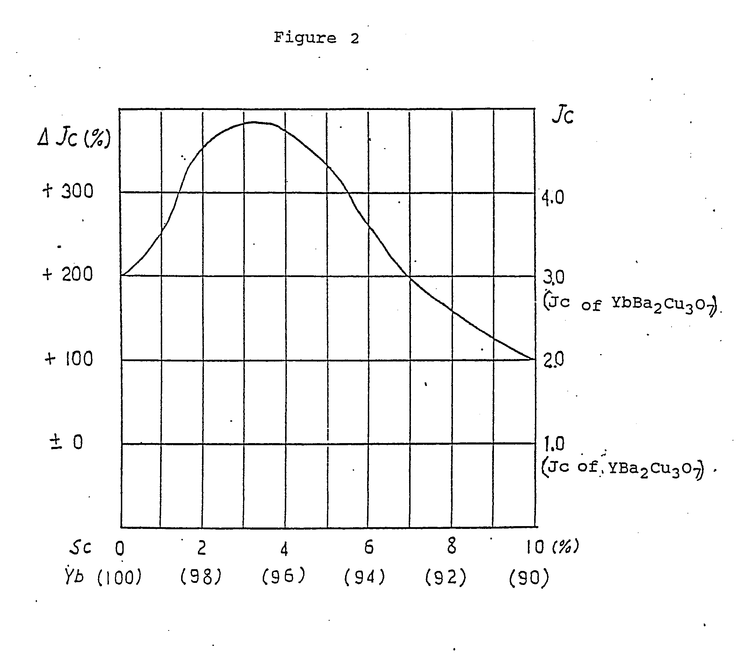

However, with regard to the selected production conditions, the rare-earth metal element compounds according to the present invention will produce a quantitative effect close to that described above. The critical current density improvement effects resulting from the rare-earth metal element compounds are shown in Figures 1 to 4.

Example 1

Finely-powdered oxalates of Y (yttrium), Sc (scandium), Ba (barium), and Cu (copper) blended to produce an atomic ratio of Z:Ba:Cu = 1:2:3 (wherein Z is a mixture of Y and Sc in a ratio Y: 80 to 97%, Sc: 3 to 20% (atomic percentage)) were subjected to preliminary sintering at 900°C for 2 hours, and were then pulverized. The powder was then subjected to oxygen enrichment treatment by maintaining it in an oxygen enrichment atmosphere at 850°C for 5 hours, after which it was given a primary pressing to form it into pellets 20 mm in diameter, then molded by cold isotropic pressing at a pressure of 2000 kgf/cm² and heat-treated (pre-sintering) for 8 hours at 950°C to form sintered bodies of superconductive ceramics constituted substantially of $Z_1Ba_2Cu_3O_7$. The sintered bodies were pulverized to provide a superconductive powder of $(Y, Sc)_1Ba_2Cu_3O_7$.

A small amount of a fine powder of AgO was added to the superconductive ceramics powder to form an auxiliary source of oxygen in a tubular member into which the powder is to be packed. The AgO powder was thoroughly mixed to ensure sufficient homogeneity. The powder was then packed into the said metal tubular member having an outside diameter of 20 mm and possessing a single or double layer structure. The tubular member was subjected to diametrical reduction by aperture rolling and/or drawing to form it into a wire-like form having a final diameter of 2 mm. This was followed by heat treatment (finish sintering) consisting of heating it at 950°C for 8 hours and allowing it to cool in the furnace, to form a superconductive material having a conductive portion that is substantially $Z_1Ba_2Cu_3O_7$ and with the surface of the conductive portion having a metal covering in the longitudinal orientation.

A superconductor and the material thereof consisting substantially of $YBa_2Cu_3O_7$ was produced by the same method as the above for purposes of comparison with the Sc-Y compound $Z_1Ba_2Cu_3O_7$ according to the present invention.

Typical production processes for producing the above $Z_1Ba_2Cu_3O_7$, i.e., $(Y, Sc)_1Ba_2Cu_3O_7$ and $YBa_2Cu_3O_7$ superconductors and the materials thereof are listed in Table 1. Table 2 shows the effects on the superconductivity of an Sc-Y compound produced under the reference production conditions listed in Table 1. From Table 2, it can be recognized that with respect to the superconductive oxide of this example, the Sc-Y mixture provided a critical temperature Tc that is the same as or better than that provided by Y alone, and that at a specific temperature (77 K) the critical current density Jc is greatly improved with an Sc ratio range of 3 to 20% (Y: 80 to 97%)


Example 2

Superconducting particles of $(Y, Sc)_1Ba_2Cu_3O_7$ were produced in the same way as in the above Example 1.

The superconductive ceramics particles were then packed into a metal tubular member having an outside diameter of 20 mm and possessing a single or double layer structure. The tubular member was subjected to diametrical reduction by aperture rolling and/or drawing, followed by rolling to flatten it into a strip with a finish thickness of 3 mm. A laser beam cutter was then used to cut off both ends and to cut the strip into 7 strips, each 10 mm wide. Before and/or after this cutting, heat treatment (finish sintering) was carried out consisting of heating the material at 950°C for 8 hours and allowing it to cool in the furnace, to form a superconductive material wherein the conductive portion was composed substantially of $Z_1Ba_2Cu_3O_7$ and which had a rectangular cross-section, part of the surface of the conductive portion having a metal covering in the longitudinal direction (two opposite sides of the rectangle, in this case), and part having no covering.

A superconductor and the material thereof consisting substantially of $YBa_2Cu_3O_7$ was produced by the same method as the above for purposes of comparison with the Sc-Y compound $Z_1Ba_2Cu_3O_7$ according to the present invention.

Typical production processes for producing the above $Z_1Ba_2Cu_3O_7$, i.e., $(Y, Sc)_1Ba_2Cu_3O_7$ and $YBa_2Cu_3O_7$ superconductors and the materials thereof are listed in Table 3. Table 4 shows the effects on the superconductivity of an Sc-Y compound produced under the reference production conditions listed in Table 3. From Table 4, it can be recognized that with respect to the superconductive oxide of this example, the Sc-Y mixture provided a critical temperature Tc that is the same as or better than that provided by Y alone, and that at a specific temperature (77 K) the critical current density Jc is greatly improved with an Sc ratio range of 3 to 20% (Y: 80 to 97%), exactly the same as in the case of Example 1 (Table 2).

If Examples 1 and 2 are compared more rigorously, it can be seen that the embodiment of the present invention in Example 2 has slightly better superconductivity characteristics than the embodiment of Example 1, a discrepancy that comes from differences in production conditions based on differences in the specifications of the end product (superconductive material). Specifically, in the case of Example 2, it is easy to obtain better superconductivity owing to the presence of the uncovered surface portion, via which, during the (secondary) finish sintering, replenishment of oxygen from the atmosphere is facilitated, while on the other hand the totally covered nature of the surface in Example 1 makes it difficult for oxygen to be replenished from the outside. Because of this, in the embodiment of Example 1 and similar examples (Examples 3, 5 and 7), AgO powder is used to provide an internal source of oxygen. It is very effective method; although it is not specifically stated herein, when AgO powder is not employed as an additive the characteristics are inferior.

With respect to the production of superconductive ceramics according to this invention, something that is of equal importance to the means of providing oxygen is the method used to blend (synthesize) the raw powder. As shown in Tables 1 and 3, instead of relying on the conventionally-employed oxides/carbonate methods (in which oxides or carbonates of the various raw materials are used as starting materials), the inventors used an oxalate method which provided good results. The oxalate method comprises adding a solution containing ions of rare-earth elements, alkaline earth elements and copper to an alcohol solution of oxalic acid to precipitate oxalates of the rare-earth elements, the alkaline earth elements and the copper. Ammonia water is then added to the solution in which oxalates are precipitated to adjust the pH thereof to 2 to 7. The said solution is then filtered to obtain oxalates of the rare-earth elements, the alkaline earth elements and the copper. Compared to the oxides/ carbonates method, the oxalate method provides starting materials that are far finer and have a more uniform dispersion, and as this produces dense ceramics sintered bodies, it is very effective for providing high-level superconductivity stability. Because of this, the oxalate method was used to form the starting powders for the embodiments according to the present invention and for the comparison examples.

Example 3

A starting material comprised of finely-powdered oxalates of Yb (ytterbium), Sc (scandium), Ba (barium), and Cu (copper) blended to produce an atomic ratio of Z:Ba:Cu = 1:2:3 (wherein Z is a mixture of Yb and Sc in a ratio Yb: 94 to 99%, Sc: 1 to 6% (atomic percentage)) was subjected to the same processing, from preliminary sintering onwards, as the material of Example 1 to form a superconductive material having a conductive portion that is substantially $Z_1 Ba_2 Cu_3 O_7$ and with the surface of the conductive portion having a metal covering in the longitudinal orientation.

A superconductor and the material thereof consisting substantially of $YBa_2 Cu_3 O_7$ was produced by the same method as the above for purposes of comparison with the Sc-Yb compound $Z_1 Ba_2 Cu_3 O_7$ according to the present invention.

Typical production processes for producing the above $Z_1 Ba_2 Cu_3 O_7$, i.e., $(Yb, Sc)_1 Ba_2 Cu_3 O_7$ and $YBa_2 Cu_3 O_7$ superconductors and the materials thereof are listed in Table 1. Table 25 shows the effects on the superconductivity of an Sc-Yb compound produced under the reference production conditions listed in Table 1. From Table 5, it can be recognized that with respect to the superconductive oxide of this example, the Sc-Yb mixture provided a critical temperature Tc that is the same as or better than that provided by Y or Yb alone, and that at a specific temperature (77 K) the critical current density Jc is greatly improved with an Sc ratio range of 1 to 6% (Yb: 94 to 99%).

Example 4

For the superconductive material. raw powders of $(Yb, Sc)_1 Ba_2 Cu_3 O_7$ were blended to form starting materials which were subjected to the same production processes as in the Example 3 to form a superconductive material having a conductive portion composed substantially of $Z_1 Ba_2 Cu_3 O_7$ and having a rectangular cross-section, part of the surface of the conductive portion having a metal covering in the longitudinal direction (two opposite sides of the rectangle, in this case), and part having no covering.

A superconductor and the material thereof consisting substantially of $YBa_2 Cu_3 O_7$ was produced by the same method as the above for purposes of comparison with the Sc-Yb compound $Z_1 Ba_2 Cu_3 O_7$ according to the present invention.

Typical production processes for producing the above $Z_1 Ba_2 Cu_3 O_7$, i.e., $(Yb, Sc)_1 Ba_2 Cu_3 O_7$ and $YBa_2 Cu_3 O_7$ superconductors and the materials thereof are listed in Table 3, while Table 6 shows the effects on the superconductivity of an Sc-Yb compound produced under the reference production conditions listed in Table 3. From Table 6, it can be recognized that with respect to the superconductive oxide of this example, the Sc-Yb mixture provided a critical temperature Tc that is the same as or better than that provided by Y or Yb alone, and that at a specific temperature (77 K) the critical current density Jc is greatly improved with an Sc ratio range of 1 to 6% (Yb: 94 to 99%), exactly the same as in the case of Example 3 (Table 5).

Example 5

Starting materials comprised of finely-powdered oxalates of Yb (ytterbium), Y (yttrium), Ba (barium), and Cu (copper) blended to produce an atomic ratio of Z:Ba:Cu = 1:2:3 (wherein Z is a mixture of Yb and Y in a ratio Yb: 50 to 85%, Y: 15 to 5% (atomic percentage)) were subjected to the same processing, from preliminary sintering onwards, as the material of Example 1 to form a superconductive material having a conductive portion that is substantially $Z_1Ba_2Cu_3O_7$ and with the surface of the conductive portion having a metal covering in the longitudinal orientation.

A superconductor and the material thereof consisting substantially of $YBa_2Cu_3O_7$ was produced by the same method as the above for purposes of comparison with the Y-Yb compound $Z_1Ba_2Cu_3O_7$ according to the present invention.

Typical production processes for producing the above $Z_1Ba_2Cu_3O_7$, i.e., $(Yb, Y)_1Ba_2Cu_3O_7$ and $YBa_2Cu_3O_7$ superconductors and the materials thereof are listed in Table 1. Table 7 shows the effects on the superconductivity of an Y-Yb compound produced under the reference production conditions listed in Table 1. From Table 7, it can be recognized that with respect to the superconductive oxide of this example, the Y-Yb mixture provided a critical temperature Tc that is the same as or better than that provided by Y alone, and that at a specific temperature (77 K) the critical current density Jc is greatly improved with an Y ratio range of 15 to 50% (Yb: 50 to 85%).

Example 6

For the superconductive material, raw powders of $(Yb, Y)_1Ba_2Cu_3O_7$ were blended to form starting materials which were subjected to the same production processes as in Example 2 to form a superconductive material having a conductive portion composed substantially of $Z_1Ba_2Cu_3O_7$ and having a rectangular cross-section, part of the surface of the conductive portion having a metal covering in the longitudinal direction (two opposite sides of the rectangle, in this case), and part having no covering.

A superconductor and the material thereof consisting substantially of $YBa_2Cu_3O_7$ was produced by the same method as the above for purposes of comparison with the Sc-Yb compound $Z_1Ba_2Cu_3O_7$ according to the present invention.

Typical production processes for producing the above $Z_1Ba_2Cu_3O_7$, i.e., $(Yb, Y)_1Ba_2Cu_3O_7$ and $YBa_2Cu_3O_7$ superconductors and the materials thereof are listed in Table 3, while Table 8 shows the effects on the superconductivity of an Y-Yb compound produced under the reference production conditions listed in Table 3. From Table 8, it can be recognized that with respect to the superconductive oxide of this example, the Y-Yb mixture provided a critical temperature Tc that is the same as or better than that provided by Y alone, and that at a specific temperature (77 K) the critical current density Jc is greatly improved with an Y ratio range of 15 to 50% (Yb: 50 to 85%), exactly the same as in the case of Example 5 (Table 7).

Example 7

Finely-powdered oxalates of Yb (ytterbium), Y (yttrium), Sc (scandium), Ba (barium), and Cu (copper) blended to produce an atomic ratio of Z:Ba:Cu = 1:2:3 were used to prepare the raw powder of an Sc-Y-Yb system superconductor. Here, $Z = Z' + Sc = (Yb + Y) + Sc$, $Z'$ being a mixture of Yb and Y in a ratio Yb: 50 to 85%, Y: 15 to 50% (atomic percentage), with Z being made a mixture of 0.2 to 2.0% Sc of the above $Z'$, and $Z'$, i.e., (Yb + Y) (by atomic ratio).

The starting material formed by the powder thus blended was subjected to the same processing, from preliminary sintering onwards, as the material of Example 1 to form a superconductive material having a conductive portion that is substantially $Z_1Ba_2Cu_3O_7$ and with the surface of the conductive portion having a metal covering in the longitudinal direction.

With respect to the thus-produced $Z_1Ba_2Cu_3O_7$, i.e., $(Yb, Y, Sc)_1Ba_2Cu_3O_7$, shown in Table 9 are representative examples of the critical current density (Jc) improvement effect obtained by the addition of Sc to (Yb + Y). It can be seen from Table 9 that when the ratio of added Sc relative to $Z'$, i.e., Sc/(Y + Yb), is 1%, within an Y-Yb mixture ratio range of Y: 15 to 50% (Yb: 50 to 85%) there is an improvement of about 50% in the Jc compared with when no Sc is added. Therefore, if the Jc with $(Yb, Y, Sc)_1Ba_2Cu_3O_7$ is compared to that with $YBa_2Cu_3O_7$, the effect of the Y-Yb mixture combines with the effect of the addition of Sc for an improvement of 350% or more within the range Y: 30 to 40% (Yb: 60 to 70%). Moreover, while the level of the $J'c$ (critical current density when no Sc is added) with a ratio of Y: 30 to 40% is approximately the same as that the $J'C$ with a ratio of Yb: 100%, it was found that with a Jc that includes the effect of the addition of Sc, a Y: 30 to 40% composition is plainly superior to Yb alone.

Furthermore, even though the ratio of added Sc may be the same, depending on the Y-Yb mixture ratio, differences arise in the Jc improvement effect relative to the $J'c$. If the effect of the Y-Yb mixture and the effect of the Sc addition are synthesized, with regard to the Sc-Y-Yb mixture, while an yttrium range of Y: 15 to 50% is good, Y: 20 to 45% is better and Y: 30 to 40% is best. Although details are not included herein, in the Y: 20 to 45% range an addition of 0.2% Sc improves the Jc by about 10%, compared with the $J'c$. The relationship between increases in the Sc and the improvement in the Jc is more less linear until the ratio of added Sc reaches about 1%, which is more or less saturation. More than 2% Sc will in fact result in a reduction in the Jc.

Example 8

Similarly to Example 7, the raw powders of a Sc-Y-Yb system superconductor were blended to form the starting material which was then subjected to the same processing as that described in Example 2 to form an end superconductive material having a conductive portion with a composition that is substantially $Z_1Ba_2Cu_3O_7$, and a rectangular cross-section, part of the surface of the conductive portion having a metal covering in the longitudinal direction and part being left uncovered.

With respect to the thus-produced $Z_1Ba_2Cu_3O_7$, i.e., $(Yb, Y, Sc)_1Ba_2Cu_3O_7$, shown in Table 10 are representative examples of the critical current density (Jc) improvement effect obtained by the addition of Sc to (Yb + Y). It can be seen from Table 10 that when the ratio of added Sc relative to $Z'$, i.e., Sc/(Y + Yb), is 1%, within an Y-Yb mixture ratio range of Y: 15 to 50% (Yb: 50 to 85%) there is an improvement of about 50% in the Jc compared with when no Sc is added, the same as in the case of Example 7 (Table 9).

Table 1

| Process | Process details | Reference conditions | Other possible conditions |
|---|---|---|---|
| 1 | Preparation of raw powders | Oxalate method | Oxide-carbonate method[**] |
| 2 | Molding | (By usual methods) | (May be omitted)[*] |
| 3 | Calcining | 900°C x 2 hours | |
| 4 | Pulverizing | (By usual methods) | |
| 5 | Oxygen enrichment | 850°C x 5 hours $O_2$ enrichment atmosphere | (May be omitted)[**] |
| 6 | Mixing | (By usual methods) | |
| 7 | Primary molding | Uniaxial pressurization method | |
| 8 | Secondary molding | Cold isotropic pressing | |
| 9 | Pre-sintering | 950°C x 8 hours | |
| 10 | Pulverizing | (By usual methods) | |
| 11 | Mixing with oxygen source | AgO powder | (May be omitted)[**] |
| 12 | Insertion into tubular member | 2-layer pipe (inner layer:18-8 stainless steel) (outer layer:copper) | Copper pipe[**] |
| 13 | Diameter-reduction | Aperture rolling and/or drawing | |
| 14 | Finish sintering | 950°C x 8 hours → Gradual cooling in a furnace | |

Notes  * Characteristics slightly below reference condition.

** Characteristics well below reference condition.

EP 0 292 940 A2

EP 0 292 940 A2

Table 2

(Example 1)

| | Production conditions | Sc : Y | Superconductivity | | Jc improvement |
|---|---|---|---|---|---|
| | | | $T_c$ (K) | $J_c$ (A/cm$^2$) | |
| Embodiment of this invention | Reference conditions listed in Table 1 | 1 : 99 | 90 | 370 | + 6% |
| | | 3 : 97 | 90 | 420 | + 20% |
| | | 5 : 95 | 91 | 690 | + 97% |
| | | 8 : 92 | 92 | 1040 | +197% |
| | | 12 : 88 | 92 | 1060 | +203% |
| | | 15 : 85 | 91 | 700 | +100% |
| | | 20 : 80 | 90 | 430 | + 23% |
| | | 30 : 70 | 89 | 160 | − 54% |
| Comparative examples | do. | 100: 0 | (≈30) | − | − |
| | | 0:100 | 90 | 350 | ±0 |

Note: Tc: critical temperature

Jc: critical current density at 77 K

Table 3

| Process | Process details | Reference conditions | Other possible conditions |
|---|---|---|---|
| 1 | Preparation of raw powders | Oxalate method | Oxide-carbonate method** |
| 2 | Molding | (By usual methods) | (May be omitted)* |
| 3 | Calcining | 900°C x 2 hours | |
| 4 | Pulverizing | (By usual methods) | |
| 5 | Oxygen enrichment | 850°C x 5 hours $O_2$ enrichment atmosphere | (May be omitted)** |
| 6 | Mixing | (By usual methods) | |
| 7 | Primary molding | Uniaxial pressurization method | |
| 8 | Secondary molding | Cold isotropic pressing | |
| 9 | Pre-sintering | 950°C x 8 hours | |
| 10 | Pulverizing | (By usual methods) | |
| 11 | Insertion into tubular member | 18-8 stainless steel pipe | Copper pipe* |
| 12 | Diameter-reduction | Aperture rolling and/or drawing | |
| 13 | Flattening | Flat rolling | |
| 14 | Primary finish sintering | 950°C x 8 hours → Gradual cooling in a furnace | (May be omitted)* |
| 15 | Longitudinal cutting | By laser beam | |
| 16 | Secondary finish sintering | 950°C x 8 hours → Gradual cooling in a furnace $O_2$ enrichment atmosphere | |

Notes * Characteristics slightly below reference condition.

** Characteristics well below reference condition.

EP 0 292 940 A2

EP 0 292 940 A2

## Table 4

(Example 2)

| | Production conditions | Sc : Y | Superconductivity | | Jc Improvement |
|---|---|---|---|---|---|
| | | | $T_c$ (K) | $J_c$ (A/cm²) | |
| Embodiment of this invention | Reference conditions listed in Table 3 | 1 : 99 | 91 | 450 | + 7% |
| | | 3 : 97 | 91 | 510 | + 21% |
| | | 5 : 95 | 92 | 860 | +105% |
| | | 10 : 90 | 92 | 1320 | +214% |
| | | 15 : 85 | 92 | 880 | +110% |
| | | 20 : 80 | 91 | 500 | + 19% |
| Comparative examples | do. | 100: 0 | (≈30) | - | - |
| | | 0:100 | 91 | 420 | ± 0 |

Note: Tc: critical temperature

Jc: critical current density at 77 K

## Table 5

(Example 3)

| | Production conditions | Sc : Yb | Superconductivity | | Jc Improvement($\Delta J_c$) | |
|---|---|---|---|---|---|---|
| | | | $T_c$ (K) | $J_c$ (A/cm$^2$) | Relative to $YBa_2Cu_3O_7$ | Relative to $YbBa_2Cu_3O_7$ |
| Embodiment of this invention | Reference conditions listed in Table 1 | 0 : 100 | 91 | 1060 | +203% | ± 0% |
| | | 0.5 : 99.5 | 91 | 1130 | +223% | + 7% |
| | | 1 : 99 | 91 | 1270 | +263% | +20% |
| | | 1.5 : 98.5 | 92 | 1440 | +311% | +36% |
| | | 2 : 98 | 92 | 1600 | +357% | +51% |
| | | 4.5 : 95.5 | 92 | 1620 | +363% | +53% |
| | | 5.5 : 94.5 | 92 | 1410 | +303% | +33% |
| | | 6 : 94 | 91 | 1280 | +266% | +21% |
| | | 8 : 92 | 90 | 920 | +163% | −13% |
| Comparative examples | do. | 100 : 0 | (≈30) | — | — | — |
| | | $YBa_2Cu_3O_7$ | 90 | 350 | ± 0 | −67% |

Note:  Tc: critical temperature

Jc: critical current density at 77 K

Table 6

<div align="right">(Example 4)</div>

| | Production conditions | Sc : Yb | Superconductivity | | Jc improvement$(\Delta J_c)$ | |
|---|---|---|---|---|---|---|
| | | | $T_c$ (K) | $J_c$ (A/cm$^2$) | Relative to YBa$_2$Cu$_3$O$_7$ | Relative to YbBa$_2$Cu$_3$O$_7$ |
| Embodiment of this invention | Reference conditions listed in Table 3 | 0 : 100 | 91 | 1270 | +202% | ± 0% |
| | | 0.5 : 99.5 | 91 | 1370 | +226% | + 8% |
| | | 1 : 99 | 92 | 1550 | +269% | +22% |
| | | 1.5 : 98.5 | 92 | 1720 | +310% | +35% |
| | | 3 : 97 | 92 | 2020 | +381% | +59% |
| | | 5.5 : 94.5 | 92 | 1690 | +302% | +33% |
| | | 6 : 94 | 92 | 1540 | +267% | +21% |
| Comparative examples | do. | 100 : 0 | (≈30) | — | — | — |
| | | YBa$_2$Cu$_3$O$_7$ | 91 | 420 | ± 0 | −67% |

Note: Tc: critical temperature

Jc: critical current density at 77 K

EP 0 292 940 A2

EP 0 292 940 A2

Table 7

(Example 5)

| | Production conditions | Y : Yb | Superconductivity | | Jc improvement |
|---|---|---|---|---|---|
| | | | $T_c$ (K) | $J_c$ (A/cm$^2$) | vs. $YBa_2Cu_3O_7$ |
| Embodiment of this invention | Reference conditions listed in Table 1 | 0:100 | 91 | 1270 | +203% |
| | | 5 : 95 | 91 | 850 | +106% |
| | | 8 : 92 | 91 | 640 | + 54% |
| | | 10 : 90 | 90 | 200 | − 51% |
| | | 15 : 85 | 91 | 650 | + 54% |
| | | 20 : 80 | 92 | 870 | +111% |
| | | 35 : 65 | 92 | 1300 | +197% |
| | | 45 : 55 | 92 | 850 | +106% |
| | | 50 : 50 | 92 | 650 | + 51% |
| Comparative example: | do. | 100: 0 | 91 | 420 | ± 0 |

Note: Tc: critical temperature

Jc: critical current density at 77 K

Table 8

(Example 6)

| | Production conditions | Y : Yb | Superconductivity | | Jc improvement |
|---|---|---|---|---|---|
| | | | $T_c$ (K) | $J_c$ (A/cm$^2$) | vs. $YBa_2Cu_3O_7$ |
| Embodiment of this invention | Reference conditions listed in Table 3 | 0:100 | 91 | 1060 | +203% |
| | | 5 : 95 | 91 | 720 | +106% |
| | | 8 : 92 | 90 | 540 | + 54% |
| | | 10 : 90 | 89 | 170 | − 51% |
| | | 15 : 85 | 90 | 540 | + 54% |
| | | 20 : 80 | 91 | 740 | +111% |
| | | 30 : 70 | 92 | 1040 | +197% |
| | | 40 : 60 | 92 | 1060 | +203% |
| | | 45 : 55 | 91 | 720 | +106% |
| | | 50 : 50 | 91 | 530 | + 51% |
| | | 75 : 25 | 90 | 410 | + 17% |
| Comparative example | do. | 100: 0 | 90 | 350 | ± 0 |

Note:  Tc: critical temperature

Jc: critical current density at 77 K

Table 9

(Example 7)

| | Production conditions | Y : Yb | Sc / (Y+Yb) | Superconductivity value | | | Jc improvement($\Delta J_c$) | |
|---|---|---|---|---|---|---|---|---|
| | | | | $T_c$ (K) | $J'_c$ (A/cm²) | $J_c$ (A/cm²) | vs. $YBa_2Cu_3O_7$ | vs. $J'_c$ |
| Embodiment of this invention | Reference conditions listed in Table 1 | 0:100 | 1 % | 92 | 1060 | 1270 | + 263% | + 20% |
| | | 5:95 | " | 92 | 720 | 870 | + 149% | + 21% |
| | | 8:92 | " | 91 | 540 | 660 | + 89% | + 22% |
| | | 10:90 | " | 90 | 170 | 200 | − 43% | + 18% |
| | | 15:85 | " | 91 | 540 | 800 | + 129% | + 48% |
| | | 20:80 | " | 92 | 740 | 1120 | + 220% | + 51% |
| | | 30:70 | " | 92 | 1040 | 1580 | + 351% | + 52% |
| | | 40:60 | " | 92 | 1060 | 1620 | + 363% | + 53% |
| | | 45:55 | " | 92 | 720 | 1110 | + 217% | + 54% |
| | | 50:50 | " | 92 | 530 | 820 | + 134% | + 55% |
| | | 75:25 | " | 91 | 410 | 470 | + 34% | + 15% |
| Comparative examples | do. | 100: 0 | 0 | 90 | 350 | — | ± 0% | — |
| | | $ScBa_2Cu_3O_7$ | — | ( ≈ 30) | — | — | — | — |

Note:  Tc: critical temperature

J'c: critical current density at 77 K when no Sc has been added (See Table 7)

Jc: critical current density at 77 K

## Table 10

(Example 8)

| | Production conditions | Y : Yb | Sc / (Y+Yb) | Superconductivity value | | | Jc improvement $(\Delta J_c)$ | |
|---|---|---|---|---|---|---|---|---|
| | | | | $T_c$ (K) | $J'_c$(A/cm²) | $J_c$ (A/cm²) | , $YBa_2Cu_3O_7$ | $J'_c$ |
| Embodiment of this invention | Reference conditions listed in Table 3 | 0:100 | 1 % | 92 | 1270 | 1550 | + 269% | + 22% |
| | | 5:95 | " | 92 | 850 | 1030 | + 145% | + 21% |
| | | 8:92 | " | 92 | 640 | 770 | + 83% | + 20%. |
| | | 10:90 | " | 91 | 200 | 240 | − 43% | + 20% |
| | | 15:85 | " | 92 | 650 | 980 | + 133% | + 51% |
| | | 20:80 | " | 92 | 870 | 1320 | + 214% | + 52% |
| | | 35:65 | " | 92 | 1300 | 2000 | + 376% | + 54% |
| | | 45:55 | " | 92 | 850 | 1310 | + 212% | + 53% |
| | | 50:50 | " | 92 | 650 | 1000 | + 138% | + 54% |
| Comparative examples | do. | 100: 0 | 0 | 91 | 420 | — | ± 0 | — |
| | | $ScBa_2Cu_3O_7$ | — | ( ≈ 30) | — | — | — | — |

Note:  Tc: critical temperature

J'c: critical current density at 77 K when no Sc has been added (See Table 7)

Jc: critical current density at 77 K

EP 0 292 940 A2

## Claims

1. A superconductor having a composition that is substantially $Z_1Ba_2Cu_3O_7$, wherein Z is one selected from among four comprised of: a mixture of Y (yttrium) and Sc (scandium) in a ratio (by atomic percentage) of Y: 80 to 97%, Sc: 3 to 20%; a mixture of Yb (ytterbium) and Sc in a ratio (by atomic percentage) of Yb: 94 to 99%, Sc: 1 to 6%; a mixture of Yb and Y in a ratio (by atomic percentage) of Yb: 50 to 85%, Y: 15 to 50%; and a mixture $Z'$ of Yb and Y in a ratio (by atomic percentage) of Yb: 50 to 85%, Y: 15 to 50% mixed with Sc in a ratio (atomic ratio) of 0.2 to 2%.

2. A superconductor as claimed in claim 1 having a composition that is substantially $Z \cdot Ba_2Cu_3O_7$, wherein Z is a mixture of Y (yttrium): 85 to 95% and Sc (scandium): 5 to 15% (by atomic percentage).

3. A superconductor as claimed in claim 1 having a composition that is substantially $Z_1Ba_2Cu_3O_7$, wherein Z is a mixture of Yb (ytterbium): 94.5 to 98.5% and Sc (scandium): 1.5 to 5.5% (by atomic percentage).

4. A superconductor as claimed in claim 1 having a composition that is substantially $Z_1Ba_2Cu_3O_7$, wherein Z is a mixture of Yb (ytterbium): 55 to 80% and Y (yttrium): 20 to 45% (by atomic percentage).

5. A superconductor as claimed in claim 1 having a composition that is substantially $Z_1Ba_2Cu_3O_7$, wherein $Z'$ is a mixture of Yb (ytterbium): 55 to 80% and Y (yttrium): 20 to 45% (by atomic percentage) and Z is a mixture of 0.2 to 2% of the Sc (scandium) of the said $Z'$ and the $Z'$ Yb and Y, by atomic ratio.

EP 0 292 940 A2

Figure 1

Figure 2

Figure 3

Figure 4